# DEMANDE DE BREVET EUROPEEN

(11) **EP 4 766 091 A1**
(43) Date de publication de la demande: **24.06.2026**
(21) Numéro de dépôt: 25225462.8
(22) Date de dépôt: 19.12.2025
(51) Int. Cl.: H10D 87/00, H10D 84/80, H10W 10/17, H10D 30/01, H10W 10/00, H10W 10/10

(54) **PROCÉDÉ D'ISOLATION AU SEIN D'UN DISPOSITIF MICROÉLECTRONIQUE**

(30) Priorité: 19.12.2024 FR 2414599
(71) Demandeur: COMMISSARIAT À L'ÉNERGIE ATOMIQUE ET AUX ÉNERGIES ALTERNATIVES, 75015 Paris (FR)
(72) Inventeur: BOND, Alice, 38054 GRENOBLE Cedex 09 (FR); MOTA FRUTUOSO, Tadeu, 38054 GRENOBLE Cedex 09 (FR)
(74) Mandataire: Hautier IP

(57) **Abrégé**

L'invention concerne un dispositif microélectronique comprenant une isolation entre une première région (1000a) et une deuxième région (1000b). Le dispositif comprend un empilement (1) comprenant un substrat semiconducteur (10), une couche d'oxyde enterré (20), et une couche mince (30). L'empilement (1) comprend une première région (1000a) et une deuxième région (2000b) séparées par une zone d'isolation (1000). La zone d'isolation (1000) comprend un espaceur (200) isolant s'étendant sur des flancs internes (1a, 1b) de l'empilement (1), une couche épitaxiée (300) s'étendant entre les flancs internes (1a, 1b) de l'empilement (1), une couche séparatrice (400) isolante, s'étendant sur la couche épitaxiée (300), et un motif électriquement conducteur (500) s'étendant sur la couche séparatrice (400).

## Description

### DOMAINE TECHNIQUE

La présente invention concerne le domaine des dispositifs microélectroniques, notamment des transistors. Elle trouve par exemple pour application particulièrement avantageuse le domaine des circuits intégrés.

### ETAT DE LA TECHNIQUE

La réalisation d'un ensemble de dispositifs microélectroniques sur une même plaquette (plus couramment désignée par le terme anglais « wafer ») s'accompagne de problématiques d'isolation électrique liées d'une part à l'apparition de diodes parasites et d'autre part à l'isolation entre dispositifs.

La première problématique principale concerne donc les diodes parasites apparaissant dans certaines architectures de dispositifs. Il apparaît en effet que lorsque PMOS et NMOS sont formés dans des puits respectivement dopés n et p, des diodes parasites apparaissent à la jonction entre les puits de dopages opposés. Ces diodes parasites sont tout particulièrement gênantes lorsqu'elles se forment à la jonction entre deux puits aux dopages opposés juxtaposés horizontalement. En effet, dans ce cas, la plage de polarisation pouvant être appliquée aux dispositifs est fortement réduite.

Il est donc nécessaire de réaliser une isolation peu profonde pour s'affranchir de ces diodes parasites horizontales. Il pourrait sembler envisageable de réaliser cette isolation par un procédé d'oxydation locale (couramment désigné LOCOS, de l'anglais « Local Oxidation of Silicon »). Or, lorsque l'on met en œuvre une oxydation locale, on obtient systématiquement une extension latérale de l'oxydation non désirée, dite « bec d'oiseau », s'étendant sur au moins une vingtaine de nanomètres. Ce bec d'oiseau crée un encombrement inutile : l'emploi d'une technique d'oxydation locale nuit donc à la densité. De plus, une isolation peu profonde doit être protégée pour éviter d'être entièrement consommée au cours du procédé de fabrication. Il est donc nécessaire d'avoir une isolation de faible dimension latérale afin qu'une grille d'une largeur typique de 20 nm puisse la protéger. L'extension latérale systématiquement générée par un procédé d'oxydation locale n'est donc pas compatible.

La deuxième problématique principale concerne l'isolation électrique entre dispositifs. Deux stratégies principales existent aujourd'hui pour la réalisation d'une telle isolation.

Une première méthode consiste à faire s'étendre une grille polarisée positivement entre deux transistors PMOS (ou une grille polarisée négativement entre deux transistors NMOS), ce qui a pour effet de repousser les porteurs majoritaires de part et d'autre de la grille et d'isoler les deux transistors. Cependant, cette technique est difficilement implémentable au niveau de régions du wafer où sont fabriqués côte à côte des transistors NMOS et des transistors PMOS. En effet, l'isolation des transistors NMOS et PMOS requérant des polarisations opposées de la grille, il n'est pas possible d'utiliser une grille commune pour isoler les deux types de transistors. Il faut donc réaliser deux grilles distinctes dans le prolongement l'une de l'autre et réaliser des contacts séparés permettant de les polariser différemment, ce qui encombre le wafer et nuit à la densité.

Une deuxième méthode consiste à isoler les transistors en formant une tranchée profonde (couramment désignée STI, de l'anglais « Shallow Trench Isolation ») entre eux. Cependant, du fait de la profondeur requise et de l'état des techniques actuelles, le STI ne peut pas présenter un rapport de forme élevé, ce qui fait perdre de l'espace sur le wafer et nuit également à la densité.

Il est envisageable de combiner ces deux méthodes, par exemple en isolant les transistors PMOS à l'aide d'une grille polarisée positivement et en isolant les transistors NMOS par un STI. Dans cette solution, la grille polarisée et le STI se trouvent dans le prolongement l'un de l'autre. Cette piste n'aurait cependant d'intérêt que si le STI pouvait présenter une largeur aussi faible que la grille polarisée. Or, la grille présente typiquement une largeur de 20 nm, dimension qui n'est pas accessible pour le STI de par sa profondeur et de par les techniques actuelles, notamment les techniques de remplissage. Une autre manière de faire cette isolation est par oxydation locale. Cependant, comme décrit précédemment, une oxydation locale conduit à un bec d'oiseau s'étendant latéralement sur une vingtaine de nanomètres. Il est donc impossible avec les méthodes actuelles de parvenir à réaliser un STI de largeur comparable à la largeur de la grille polarisée. La combinaison des deux méthodes n'est donc pas satisfaisante, puisque l'on reste contraint par les limites dimensionnelles des méthodes STI ou oxydation locale.

Un objectif de la présente invention est donc de résoudre au moins une des problématiques présentées ci-dessus, et de préférence de résoudre les deux simultanément.

### RESUME

Pour atteindre cet objectif, un premier objet de l'invention concerne un dispositif microélectronique comprenant une isolation entre une première région et une deuxième région, le dispositif comprenant un empilement comprenant, selon une direction dite d'empilement :
a. un substrat à base d'un premier matériau semiconducteur, dit substrat semiconducteur,
b. une couche à base d'un matériau électriquement isolant, dite couche d'oxyde enterré,
c. une couche à base d'un deuxième matériau semiconducteur, de préférence identique au premier matériau semiconducteur, dite couche mince.

L'empilement comprend une première région et une deuxième région séparées par une zone d'isolation s'étendant entre des flancs internes de l'empilement, la zone d'isolation traversant la couche mince et la couche d'oxyde enterré et débouchant sur le substrat semiconducteur.

Le dispositif microélectronique comprenant en outre un premier transistor et un deuxième transistor, le premier transistor et le deuxième transistor se situant respectivement dans la première et dans la deuxième région, la couche mince formant un premier canal du premier transistor et un deuxième canal du deuxième transistor.

La zone d'isolation comprend avantageusement :
a. un espaceur s'étendant sur les flancs internes de l'empilement, l'espaceur étant à base d'un matériau électriquement isolant,
b. une couche à base du premier matériau semiconducteur, dite couche épitaxiée, s'étendant entre les flancs internes de l'empilement et étant au contact du substrat,
c. une couche à base d'un matériau électriquement isolant, dite couche séparatrice, s'étendant sur la couche épitaxiée, la couche séparatrice recouvrant entièrement la couche épitaxiée,
d. un motif électriquement conducteur s'étendant sur la couche séparatrice.

La couche séparatrice est en contact direct avec la couche épitaxiée, le motif électriquement conducteur est en contact direct avec la couche séparatrice, la couche séparatrice et le motif électriquement conducteur étant agencés pour pouvoir autoriser ou non une circulation de courant dans la couche épitaxiée.

Un deuxième objet de l'invention concerne un procédé de fabrication d'une zone d'isolation entre une première région et une deuxième région d'un dispositif microélectronique, le procédé comprenant les étapes suivantes :
a. fournir un empilement comprenant au moins, selon une direction dite d'empilement :
   i. un substrat à base d'un premier matériau semiconducteur, dit substrat semiconducteur,
   ii. une couche à base d'un matériau électriquement isolant, dite couche d'oxyde enterré,
   iii. une couche à base d'un deuxième matériau semiconducteur, de préférence identique au premier matériau semiconducteur, dite couche mince,
b. former une ouverture dans l'empilement, l'ouverture traversant la couche mince et la couche d'oxyde enterré et débouchant sur le substrat semiconducteur, l'ouverture étant définie par des flancs internes de l'empilement, l'ouverture séparant la première région de la deuxième région de l'empilement,
c. former un espaceur s'étendant depuis les flancs internes de l'empilement, l'espaceur étant à base d'un matériau électriquement isolant,
d. faire croître par épitaxie à partir du substrat semiconducteur une couche dite épitaxiée remplissant au moins partiellement l'ouverture,
e. former sur la couche épitaxiée une couche à base d'un matériau électriquement isolant dite couche séparatrice, la couche séparatrice recouvrant entièrement la couche épitaxiée,
f. former un motif électriquement conducteur destiné à former un motif de grille sur la couche séparatrice, la couche séparatrice étant en contact direct avec la couche épitaxiée, le motif électriquement conducteur étant en contact direct avec la couche séparatrice, la couche séparatrice et le motif électriquement conducteur étant agencés pour pouvoir autoriser ou non une circulation de courant dans la couche épitaxiée,
g. former au moins un premier transistor dans la première région et au moins un deuxième transistor dans la deuxième région, chaque transistor présentant un canal formé par la couche mince.

Aussi bien le procédé de fabrication que le dispositif selon l'invention présentent de nombreux avantages par rapport à l'art antérieur.

Tout d'abord, le procédé et le dispositif selon l'invention permettent de réaliser une double isolation :
a. Une première isolation entre le puits dopé (N ou P) dans lequel l'ensemble est typiquement formé et les régions actives des dispositifs, et ce par une zone d'isolation de petites dimensions. La présente invention permet en effet de réaliser une isolation de petites dimensions. Or, le fait que la zone d'isolation présente de petites dimensions permet de se placer dans une architecture dans laquelle le caisson dopé P est englobé dans le caisson dopé N (caisson couramment désigné « deep N-well ») (ou inversement). Dans cette architecture, les caissons dopés N et P ne sont pas juxtaposés dans le plan du substrat mais l'un sur l'autre, selon la direction verticale. Cela permet de supprimer les diodes parasites horizontales, les plus néfastes au fonctionnement, et ainsi de résoudre la première problématique soulevée en introduction.
b. Une deuxième isolation grâce à la présence de l'espaceur entre deux dispositifs formés au niveau des première et deuxième régions (typiquement deux transistors), ce qui résout la deuxième problématique soulevée en introduction.

Les deux problématiques sont donc résolues par la fabrication d'un espaceur qui, dans le procédé selon la présente invention, est réalisé de façon astucieuse afin de limiter la complexité et le coût du procédé.

Un autre avantage de l'invention est qu'il est possible d'avoir recours à un unique niveau de photolithographie pour définir des zones d'isolation entre deux dispositifs, en milieu de zone active, et des zones d'isolation séparant dispositifs et prise substrat (prise bulk), en périphérie de zone active. L'espaceur utilisé pour l'isolation en périphérie de zone active n'impacte d'ailleurs pas le fonctionnement des zones hybrides, c'est-à-dire les zones où la couche d'oxyde enterré a été retirée, typiquement présentes en périphérie du substrat.

Le procédé selon l'invention présente par ailleurs l'avantage de ne nécessiter aucune étape de polissage mécano-chimique, procédé coûteux, nuisant au rendement et altérant souvent la qualité des dispositifs.

De façon générale, le procédé selon l'invention met en oeuvre des étapes peu coûteuses (gravure, oxydation).

Par ailleurs, le procédé selon l'invention n'a pas recours à une étape d'oxydation locale comme certains procédés de l'art antérieur. Cela permet de s'affranchir du phénomène de bec d'oiseau décrit en introduction.

En outre, les dimensions de l'espaceur et de la couche épitaxiée sont définies non pas par une étape d'oxydation locale comme dans l'art antérieur mais par une étape de gravure servant à définir l'ouverture dans l'empilement. Cela permet un meilleur contrôle de ces dimensions. En conséquence, il est possible de réduire les marges prises pour la réalisation de l'isolation entre dispositifs et donc d'augmenter la densité de dispositifs fabriqués à partir d'un même empilement.

Par ailleurs, l'isolation telle que réalisée selon la présente invention est réalisable avant ou après la formation des zones actives des dispositifs se trouvant de part et d'autre de la zone d'isolation. Cela rend le procédé plus modulable.

La présente invention permet ainsi de résoudre simultanément les deux problématiques soulevées en introduction, et présente par ailleurs de nombreux avantages par rapport à l'art antérieur rendant la solution facilement intégrable aux procédés de fabrication courants et permettant à la fois une meilleure densité et un meilleur rendement de fabrication.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1N illustrent un mode de réalisation du procédé selon l'invention.
Les figures 2A à 2D sont des vues de dessus de différents ensembles de transistors fabriqués sur un même wafer. Ces figures illustrent notamment différentes dispositions des motifs électriquement conducteurs reliant les transistors. La figure 2E est une figure illustrant comment la présente invention peut être intégrée dans des zones hybrides pour réaliser l'isolation électrique entre dispositifs et prise substrat.
Les figures 3A à 3D représentent la valeur du champ électrique au sein de différents dispositifs, dont le dispositif selon la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple préféré, la couche séparatrice s'étend depuis une première portion de l'espaceur recouvrant un premier flanc interne de l'empilement jusqu'à une deuxième portion de l'espaceur recouvrant un deuxième flanc interne de l'empilement faisant face au premier flanc interne.

Selon un exemple préféré, l'espaceur présente une épaisseur e₂₀₀ mesurée selon une direction perpendiculaire aux flancs internes de l'empilement, avec e₂₀₀ supérieure ou égale à 4 nm et/ou inférieure ou égale à 10 nm, de préférence inférieure ou égale à 6 nm.

Selon un mode de réalisation préféré, l'espaceur est enterré dans l'empilement, et de préférence ne s'étend pas au-delà d'une face supérieure de la couche mince opposée à la couche d'oxyde enterré, par exemple est affleurante à la face supérieure de la couche mince.

Selon un mode de réalisation préféré, l'espaceur traverse la couche mince et la couche d'oxyde enterré et de préférence s'étend jusqu'à une face supérieure du substrat semiconducteur se trouvant en regard de la couche d'oxyde enterré.

Selon un exemple, le motif électriquement conducteur présente des flancs recouverts par des espaceurs secondaires, les espaceurs secondaires étant directement en contact avec la couche séparatrice.

Selon un exemple, la première région, la zone d'isolation et la deuxième région sont disposés selon une première direction perpendiculaire à la direction d'empilement, dans lequel l'ensemble formé par le motif électriquement conducteur et les espaceurs secondaires présente une largeur E mesurée selon la première direction, et dans lequel la couche épitaxiée présente une largeur L₃₀₀ mesurée selon la première direction, avec E>L₃₀₀.

Selon un exemple préféré, la couche séparatrice présente une épaisseur e₄₀₀, mesurée selon la direction d'empilement, supérieure ou égale à 3 nm.

Selon un exemple préféré, la couche épitaxiée présente un dopage de type P ou de type N.

Selon un mode de réalisation préféré du procédé selon le deuxième objet de l'invention, à l'issue de la croissance épitaxiale, la couche épitaxiée s'étend, selon la direction d'empilement, au moins jusqu'à la moitié de la hauteur de la couche d'oxyde enterré, de préférence s'étend au moins jusqu'à une face supérieure de la couche d'oxyde enterré opposée au substrat, de préférence s'étend au moins jusqu'à une face supérieure de la couche mince opposée à la couche d'oxyde enterré, de préférence dépasse la couche mince.

Un autre objet de l'invention concerne un procédé d'utilisation du dispositif selon le premier objet de l'invention, dans lequel le motif est électriquement conducteur, le procédé comprenant en outre une étape de polarisation dudit motif.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

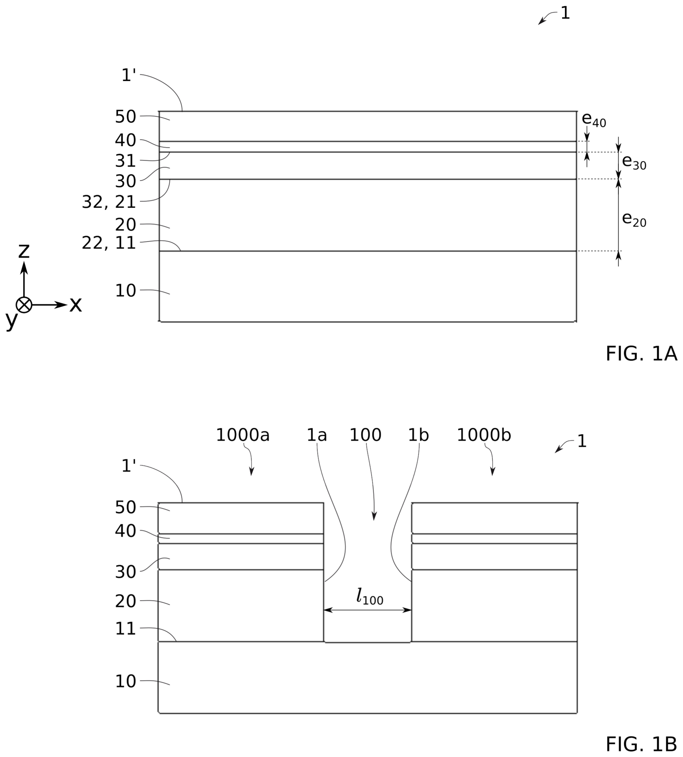

Un repère, de préférence orthonormé, comprenant les axes X, Y, Z est représenté en figure 1A. Ce repère est applicable par extension aux autres figures. La direction Z pourra être désignée « direction d'empilement ».

Dans la présente demande de brevet, on parlera préférentiellement d'épaisseur pour une couche et de hauteur pour une structure ou un dispositif. La hauteur est prise perpendiculairement au plan longitudinal XY. L'épaisseur est prise selon une direction normale au plan d'extension principal de la couche. Ainsi, une couche présente typiquement une épaisseur selon Z, lorsqu'elle s'étend principalement le long du plan longitudinal XY, et un élément en saillie, par exemple une tranchée d'isolation, présente une hauteur selon Z. Les termes relatifs « sur », « sous », « dessus », « dessous », « sous-jacent » se réfèrent préférentiellement à des positions prises selon la direction Z.

Les termes « sensiblement », « environ », « de l'ordre de » signifient « à 10% près, de préférence à 5% près ».

Un exemple de mode de réalisation du procédé selon l'invention va maintenant être décrit en référence aux figures 1A à 1N.

La figure 1A illustre la fourniture d'un empilement 1. Cet empilement comprend, empilés selon la direction d'empilement Z : un substrat semiconducteur 10, une couche d'oxyde enterré 20 et une couche mince 30. Il peut également comprendre une couche diélectrique 40 et/ou une couche de protection 50 surmontant la couche mince 30.

Le substrat 10 est à base d'un premier matériau semiconducteur, typiquement du silicium. Il présente une face supérieure 11 s'étendant principalement dans un plan XY pouvant être désigné plan transversal XY ou plan longitudinal XY. Ce plan est défini par une première direction X et une deuxième direction Y. Le plan longitudinal et la direction d'empilement Z sont typiquement perpendiculaires.

La couche d'oxyde enterrée 20 est à base d'un matériau électriquement isolante tel que du SiO₂. Elle présente une épaisseur e₂₀ mesurée selon la direction d'empilement Z. e₂₀ est par exemple supérieure ou égale à 10 nm et/ou inférieure ou égale à 145 nm, de préférence supérieure ou égale à 20 nm et/ou inférieure ou égale à 30 nm. La couche d'oxyde enterré 20 présente une face inférieure 22 en regard du substrat 10 et une face supérieure 21, opposée à sa face inférieure 22 et opposée au substrat 10.

La couche mince 30 est à base d'un deuxième matériau semiconducteur, par exemple du silicium. La couche mince 30 peut également être désignée couche active 30. Elle présente une épaisseur e₃₀ mesurée selon la direction d'empilement Z. e₃₀ est par exemple supérieure ou égale à 3 nm et/ou inférieure ou égale à 80 nm, de préférence supérieure ou égale à 5 nm et/ou inférieure ou égale à 15 nm. La couche mince 30 présente une face inférieure 32 en regard du substrat 10 et de la couche d'oxyde enterré 20, et une face supérieure 31, opposée à sa face inférieure 32 et opposée à la couche d'oxyde enterré 20.

La couche diélectrique 40 est à base d'un matériau électriquement isolant tel que du SiO2. Elle présente une épaisseur e40 mesurée selon la direction d'empilement Z. e40 est par exemple supérieure ou égale à 1nm et/ou inférieure ou égale à 10nm, de préférence supérieure ou égale à 2nm et/ou inférieure ou égale à 5nm.

La couche de protection 50 est par exemple à base de SiN.

L'empilement 1 présente une face supérieure 1', correspondant par exemple sur les figures à la face supérieure de la couche de protection 50. Celle-ci s'étend principalement dans le plan transversal XY.

Comme illustré en figure 1B, on procède ensuite à la formation d'une ouverture 100 dans l'empilement 1. L'ouverture 100 s'étend depuis la face supérieure 1' de l'empilement 1. Elle débouche sur le substrat 1, par exemple sur sa face supérieure 11. L'ouverture 100 traverse ainsi entièrement la couche de protection 50, la couche diélectrique 40 (si ces dernières sont présentes), la couche mince 30 et la couche d'oxyde enterré 20.

L'ouverture 100 peut être formée par des étapes classiques de photolithographie et gravure non illustrées.

Transversalement, l'ouverture 100 s'étend dans l'empilement 1 entre des flancs internes 1a, 1b de ce dernier définis lors de la gravure de l'ouverture 100. Les flancs internes comprennent notamment un premier flanc interne 1a et un deuxième flanc interne 1b se faisant face. L'ouverture 100 présente une largeur l₁₀₀ mesurée dans le plan transversal XY, par exemple sur les figures selon la première direction X. l₁₀₀ est typiquement supérieure ou égale à 5 nm et/ou inférieure ou égale à 100 nm, de préférence supérieure ou égale à10nm et/ou inférieure ou égale à 20nm.

L'ouverture 100 sépare deux régions de l'empilement 1 : une première région portant la référence 1000a sur la figure 1B et une deuxième région portant la référence 1000b.

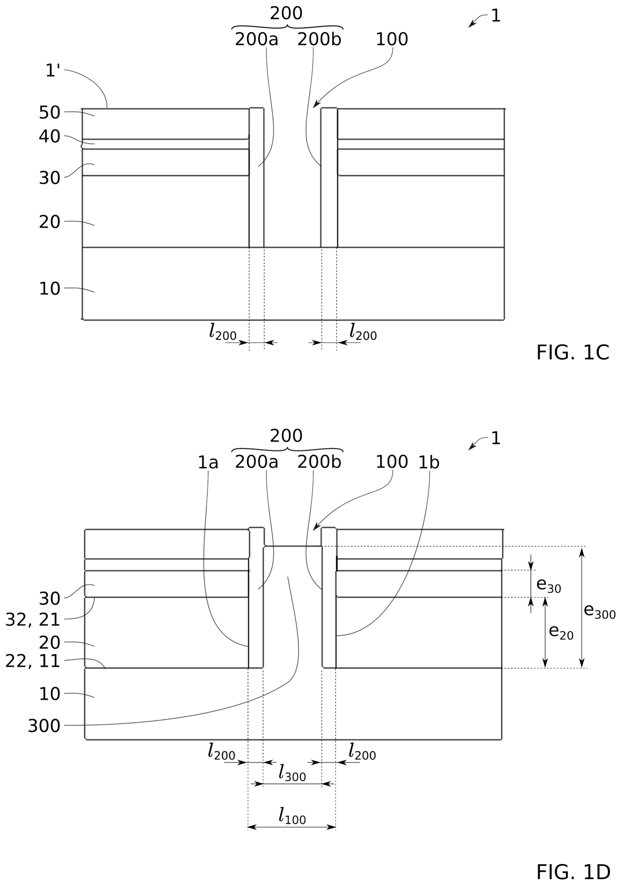

Comme illustré à la figure 1C, un espaceur 200 est ensuite formé dans l'ouverture 100, contre les flancs internes 1a, 1b de l'empilement 1. L'espaceur 200 comprend notamment une première portion 200a s'étendant depuis le premier flanc interne 1a de l'empilement et une deuxième portion 200b s'étendant depuis le deuxième flanc interne 1b de l'empilement 1.

L'espaceur 200 est à base d'un matériau électriquement isolant, tel que du SiO₂. Il peut être formé par un procédé de dépôt de couches atomiques (couramment désigné ALD, de l'anglais « Atomic Layer Deposition »), qui présente l'avantage de permettre la formation d'une couche très conforme.

La formation de l'espaceur 200 est typiquement suivie d'une gravure directionnelle pour éliminer les portions horizontales de la couche déposée située au fond de l'ouverture 100 (non représentées) et remettre à nu le substrat 10, ainsi que les portions horizontales situées sur la couche 50 (non représentées). On obtient ainsi l'ensemble illustré à la figure 1C.

L'espaceur 200 présente une largeur l₂₀₀ mesurée dans chacune de ses portions 200a, 200b. l₂₀₀ est mesurée perpendiculairement aux flancs internes 1a, 1b de l'empilement. l₂₀₀ est typiquement supérieure ou égale à 1 nm et/ou inférieure ou égale à 20 nm, de préférence supérieure ou égale à 3nm et/ou inférieure ou égale à 6 nm.

On procède ensuite à une étape de croissance par épitaxie dans l'ouverture 100, à partir du substrat 10. Cette étape permet de former une couche semiconductrice dite couche épitaxiée 300. La couche épitaxiée 300 s'étend dans l'ouverture 100 depuis la première portion 200a de l'espaceur 200 recouvrant le premier flanc interne 1a de l'empilement 1 jusqu'à la deuxième portion 200b de l'espaceur 200 recouvrant le deuxième flanc interne 2b de l'empilement 1.

La couche épitaxiée 300 présente une épaisseur e₃₀₀ mesurée selon la direction d'empilement Z. e₃₀₀ est par exemple supérieure ou égale à 15 nm et/ou inférieure ou égale à 240 nm, de préférence supérieure ou égale à 25 et/ou inférieure ou égale à 40 nm. Avantageusement, la couche épitaxiée 300 est typiquement crue de sorte à ce qu'elle s'étende au moins autant que la couche mince 30 selon la direction d'empilement Z, et de préférence qu'elle s'étende au-delà de la couche mince 30 selon la direction d'empilement Z, comme illustré sur la figure 1D. Ainsi, de préférence, e₃₀₀ ≥ e₂₀ + e₃₀. Dit autrement, la couche épitaxiée 300 traverse de préférence la couche d'oxyde enterré 20 et la couche mince 30. Un intérêt de croître la couche épitaxiée 300 au-delà de la couche mince 30 est de pouvoir former un oxyde sur cette couche épitaxiée (voir l'étape suivante de formation d'une couche séparatrice 400) sélectivement aux autres surfaces en présence, par exemple par oxydation thermique ou plasma.

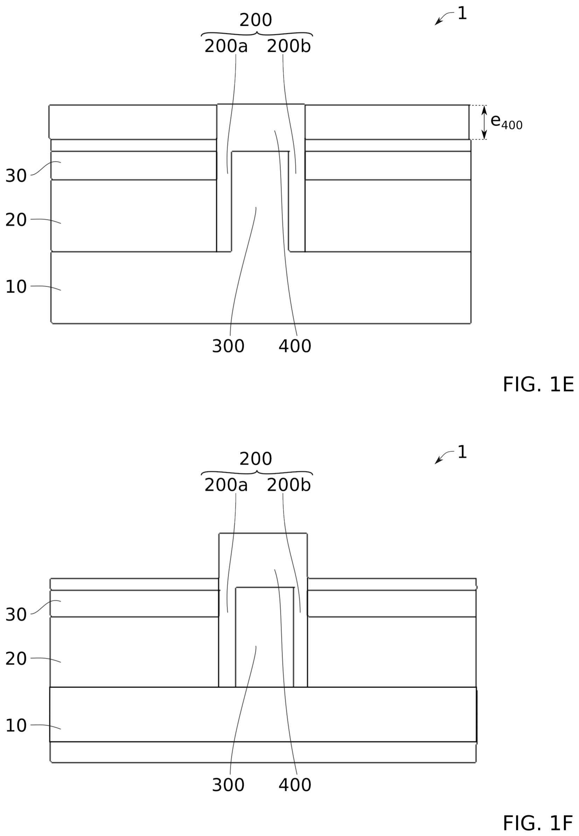

Après la formation de la couche épitaxiée 300, il est possible de procéder à la formation d'une couche séparatrice 400 au-dessus de la couche épitaxiée 300 (figure 1E). La couche séparatrice 400 est à base d'un matériau électriquement isolant, par exemple du SiO₂. La couche séparatrice 400 forme avec la première et la deuxième portion de l'espaceur 200a, 200b une unité électriquement isolante. Ces éléments isolent notamment électriquement la couche épitaxiée de la couche mince 30. La formation de la couche séparatrice 400 s'accompagne typiquement d'une oxydation partielle de la couche épitaxiée 300 depuis sa face supérieure. Cela explique aussi l'intérêt de faire croître la couche épitaxiée 300 au-delà de la dimension selon la direction Z que l'on veut lui conférer (voir figure 1D), et notamment au-delà de la couche mince 30 : son épaisseur sera réduite du fait de l'oxydation lors de la formation de la couche séparatrice 400 sus-jacente.

La couche séparatrice 400 présente une épaisseur e₄₀₀ mesurée selon la direction d'empilement Z. e₄₀₀ est par exemple supérieure ou égale à 2 nm et/ou inférieure ou égale à 10 nm, de préférence inférieure ou égale à 5 nm.

Comme illustré à la figure 1F, il est ensuite possible de retirer la couche de protection 50. On procède également de préférence à l'implantation du substrat semiconducteur 10. On forme ainsi un puits dopé.

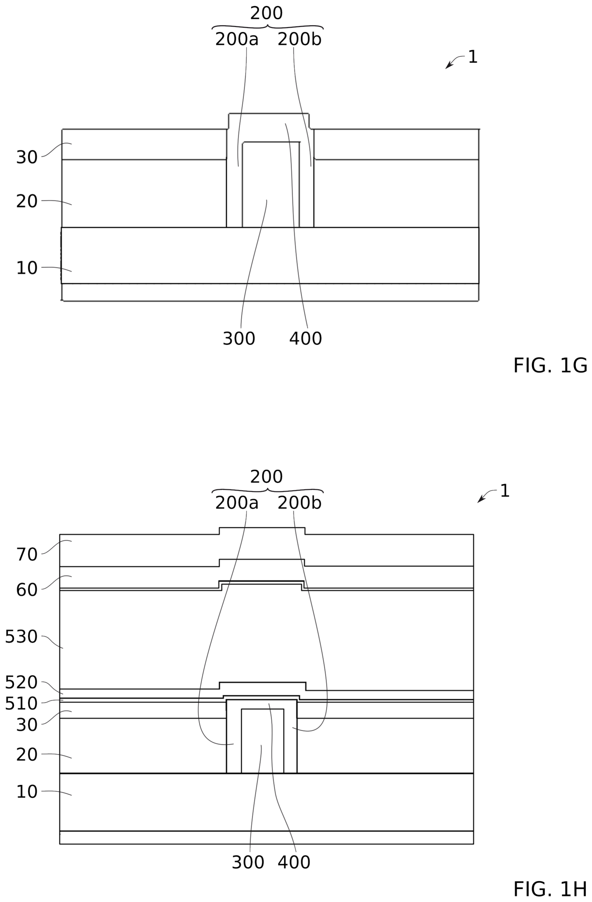

La couche diélectrique 40 peut ensuite être retirée (figure 1G), mettant ainsi à jour la couche mince 30, par exemple pour la formation de dispositifs microélectroniques.

La couche séparatrice 400 peut également être formée entre le retrait de la couche de protection 50 (figure 1F) et le retrait de la couche diélectrique 40 (figure 1G), ou encore après le retrait de la couche de diélectrique 40. La couche séparatrice 400 peut par exemple être formée lors d'une étape subséquente de formation d'une grille 500 sur la couche épitaxiée 300, entre la couche épitaxiée 300 et ladite grille 500.

A partir de l'ensemble illustré en figure 1G, on réalise deux transistors, de part et d'autre de l'espaceur 200. Les figures 1H à 1N illustrent un mode de réalisation préféré dans lequel les transistors 2000 et le motif électriquement conducteur 500 sont réalisés en même temps.

Comme illustré en figure 1H, on dépose sur l'empilement 1 un ensemble de couches destinées à former les grilles des transistors 2000a, 2000b et le motif électriquement conducteur 500. Cet ensemble de couches comprend par exemple :
- Un oxyde de grille 510,
- Un conducteur de grille 520,
- Une couche semiconductrice 530, par exemple à base de polysilicium.

Avantageusement, on dépose au-dessus de la couche-semiconductrice 530 une couche de protection 60, par exemple en nitrure.

On dépose par ailleurs un masque de gravure 70 sur la couche de protection 60. L'ensemble obtenu est illustré à la figure 1H.

On réalise ensuite une gravure au travers du masque de gravure 70 pour former dans l'empilement deux ouvertures secondaires 80 débouchant chacune sur la couche épitaxiée 300. Ces deux ouvertures secondaires 80 délimitent les grilles 2500a, 2500b des transistors 2000a, 2000b du motif électriquement conducteur 500.

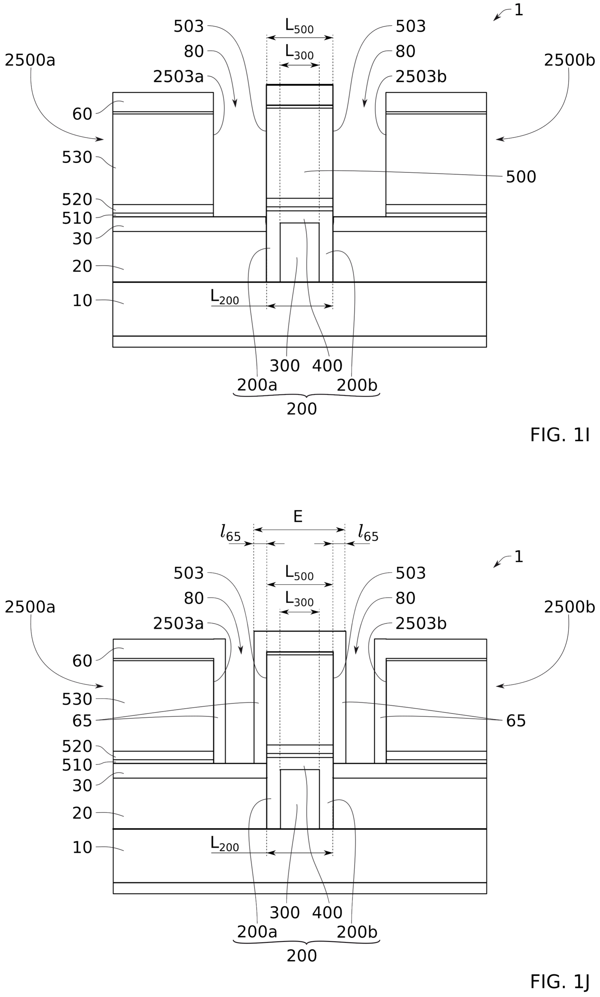

Suite à la gravure, le masque de gravure 70 est de préférence retiré. On obtient l'ensemble illustré à la figure 11. Par construction, la gravure définit la largeur L₅₀₀ du motif électriquement conducteur 500 dans le plan transversal XY. L₅₀₀ est inférieure ou égale à L₂₀₀, la dimension entre les flancs externes des portions 200a, 200b de l'espaceur 200. Cela permet d'éviter tout contact entre le motif électriquement conducteur 500 et la couche mince 30 semiconductrice. Avantageusement, L₅₀₀ est supérieure à L₃₀₀, la largeur de la couche épitaxiée 300.

L₅₀₀ et L₃₀₀ sont les dimensions respectivement du motif électriquement conducteur 500 et de la couche épitaxiée 300 dans le plan transversal XY, selon la direction dans laquelle les transistors 2000a, 2000b sont alignés (ici X). L₂₀₀ est également mesurée selon la direction dans laquelle les transistors 2000a, 2000b sont alignés. Elle est mesurée depuis le flanc de la première portion 200a de l'espaceur 200 s'étendant contre la couche d'oxyde enterré 20 jusqu'au flanc de la deuxième portion 200b de l'espaceur 200 s'étendant contre la couche d'oxyde enterré 20. L₂₀₀ est ainsi typiquement égale à l₁₀₀, la largeur de l'ouverture 100.

On forme ensuite des espaceurs secondaires 65 dans les ouvertures secondaires 80, contre les flancs 503 du motif électriquement conducteur 500 et contre les flancs 2503a, 2503b des grilles 2500a, 2500b des transistors 2000a, 2000b. Les espaceurs secondaires 65 sont à base d'un matériau électriquement isolant, typiquement à base de nitrure. Il est entendu que seule la moitié de chaque grille 2500a, 2500b est représentée et que donc un seul flanc est représenté pour chaque grille, mais que lors de cette étape, des espaceurs secondaires 65 sont avantageusement formés contre tous les flancs des grilles 2500a, 2500b.

Les espaceurs secondaires 65 présentent une largeur l₆₅ mesurées perpendiculairement aux flancs 2503a, 2503b des grilles 2500a, 2500b des transistors 2000a, 2000b et aux flancs 503 du motif électriquement conducteur 500.

La largeur de l'ensemble formé par les espaceurs secondaires 65 et le motif électriquement conducteur 500 est notée E (voir figure 1J). La largeur E est égale à 2*l₆₅+L₅₀₀. La largeur E est supérieure à L₃₀₀. De préférence, E est supérieure à L₂₀₀. Cela permet d'éviter toute mise à nu de la couche épitaxiée 300 lors des étapes ultérieures, la protégeant de l'étape subséquente de reprise d'épitaxie.

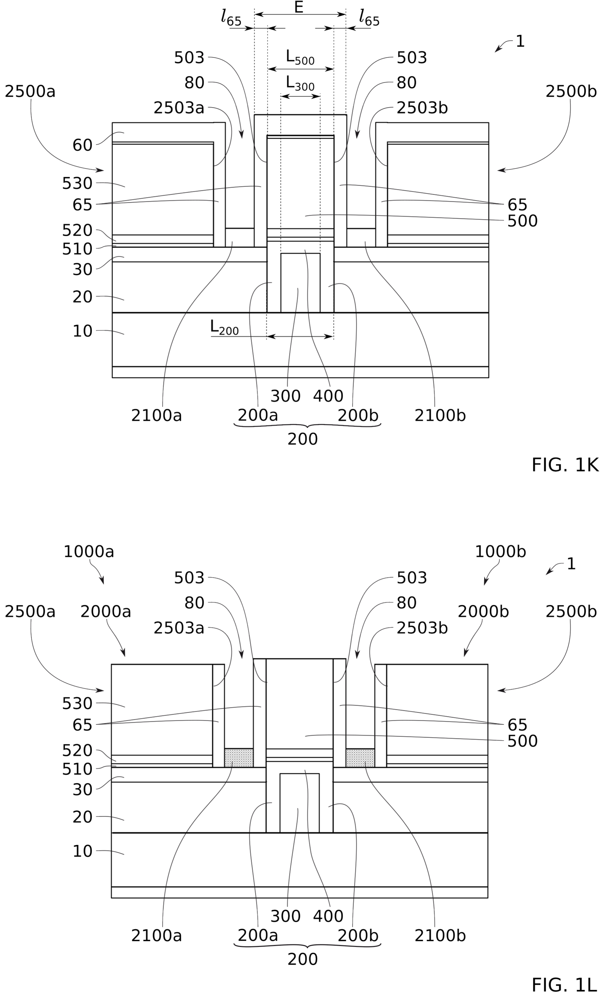

Une reprise d'épitaxie est ensuite réalisée dans les ouvertures secondaires 80 à partir de la couche mince 30. Cette croissance épitaxiale permet la formation des drains et sources 2100a, 2100b des transistors 2000a, 2000b (figure 1K). Il est à noter que seul l'un quelconque parmi le drain et la source est illustré sur les figures pour chaque transistor. Il est entendu que cette étape permet la formation d'à la fois le drain et la source de chaque transistor 2000a, 2000b.

Lors de cette étape, les espaceurs secondaires 65 servent à éviter qu'une reprise d'épitaxie se produise à partir de la couche semiconductrice 530.

On élimine ensuite la couche de protection 60 au sommet des grilles 2500a, 2500b, de préférence sélectivement. Par exemple, ce retrait peut être effectué en réalisant de nouveaux espaceurs en oxyde (non représentés) pour protéger les espaceurs secondaires 65 en nitrure.

On dope par ailleurs les sources et drains 2100a, 2100b des transistors 2000a, 2000b au travers des ouvertures secondaires 80 (voir les zones en pointillés représentant le dopage en figure 1L).

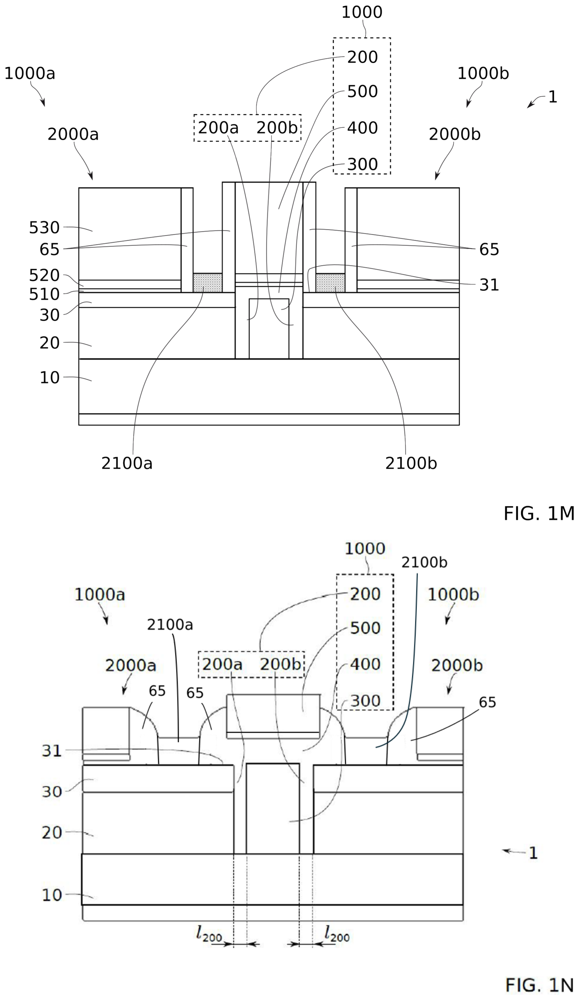

On obtient ainsi l'ensemble illustré à la figure 1M , où le premier transistor 2000ase trouve dans la première région 1000a et le deuxième transistor se trouve dans la deuxième région 2000a de l'empilement 1. Ces deux transistors 2000a, 2000b sont isolés électriquement l'un de l'autre grâce à la présence de l'espaceur 200. Une autre géométrie également envisageable est illustrée à la figure 1N. On retrouve sur la figure 1N les deux transistors 2000a, 2000b et la zone d'isolation 1000, et plus généralement tous les éléments illustrés en figure 1M.

Dans le dispositif microélectronique obtenu, le motif de grille 500 et la couche séparatrice 400 sont configurés pour pouvoir autoriser ou non la circulation de courant dans la couche épitaxiée 300. Le motif de grille 500 et la couche séparatrice 400 ont ainsi un rôle de pilotage du passage du courant dans la couche épitaxiée 300.

Par ailleurs, dans le dispositif microélectronique obtenu, on ne trouve aucune zone de matériau semiconducteur au-dessus de la zone d'isolation 1000. La zone d'isolation 1000 est uniquement recouverte par le motif électriquement conducteur 500 (ou motif de grille 500), et éventuellement les espaceurs secondaires 65 en matériau isolant. Cela permet une isolation optimale entre les transistors 2000a, 2000b, et ce grâce à une zone d'isolation 1000 de faible largeur (inférieure à 100 nm voire 50 nm et même 20 nm) permettant une densification des transistors. La réalisation du motif électriquement conducteur 500 avec le même procédé que les grilles des transistors 2000a, 2000b permet de réaliser cette isolation avec très peu de modifications par rapport à un procédé de réalisation standard. Le motif électriquement conducteur 500 se retrouve ainsi sensiblement au même niveau que les grilles des transistors 2000a, 2000b.

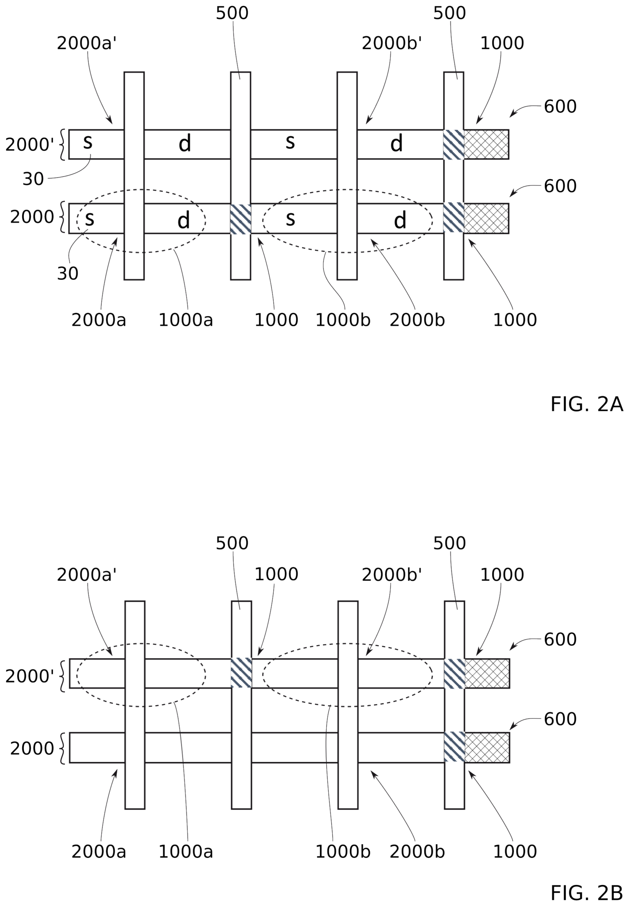

Les figures 2A à 2D sont des vues de dessus de plusieurs ensembles de transistors fabriqués sur un même wafer. Ces vues sont données à titre d'exemples d'intégration possible de la présente invention. La référence 2000 pointe sur des rangées de transistors de type NMOS et la référence 2000' sur des rangées de transistors de type PMOS. Les transistors sont représentés de façon très schématique, de sorte à permettre avant tout la compréhension de leur localisation. La référence 1000 pointe sur la zone d'isolation selon la présente invention (zone hachurée sur la figure). Pour que cette zone soit visible, le motif électriquement conducteur 500 n'a pas été illustré au niveau de cette zone, mais il est entendu qu'il y est bien présent.

Un premier exemple d'intégration de l'invention est illustré en figure 2A. Comme illustré, le motif électriquement conducteur 500 s'étend au-dessus de la région du wafer où sont disposés les transistors PMOS. Plus précisément, il s'étend entre un premier transistor PMOS 2000a' et un deuxième transistor PMOS 2000b'. En polarisant ce motif électriquement conducteur 500 positivement, on parvient à isoler électriquement ces deux transistors PMOS 2000a', 2000b' voisins. Pour des raisons de simplification des procédés de fabrication, de rationalisation des coûts et de gain de place, il est avantageux que le motif électriquement conducteur 500 se prolonge au-dessus de la région où sont disposés les transistors NMOS. La polarisation positive du motif électriquement conducteur 500 ne permet cependant pas l'isolation des transistors 2000a, 2000b NMOS voisins. La zone d'isolation 1000 selon la présente invention peut ainsi être intégrée entre les deux transistors NMOS 2000a, 2000b voisins afin de les isoler électriquement. Le motif électriquement conducteur 500 peut ainsi être commun aux zones de transistors PMOS et NMOS.

Un deuxième exemple d'intégration est illustré à la figure 2B. Dans cet exemple, le motif électriquement conducteur 500 est polarisé négativement de manière à isoler les deux transistors NMOS 2000a, 2000b voisins. La zone d'isolation 1000 selon la présente invention est intégrée entre les deux transistors PMOS 2000a', 2000b' voisins.

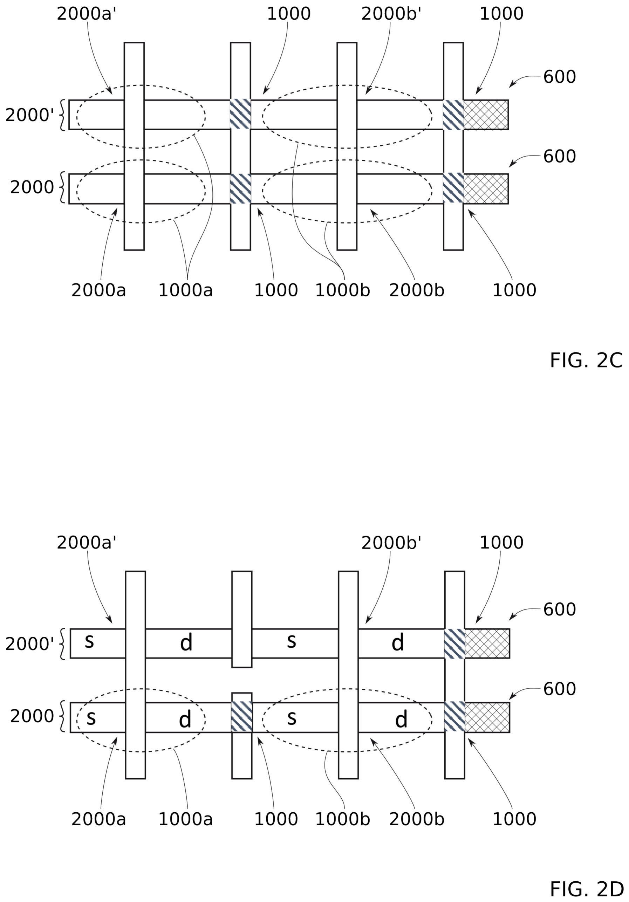

Selon un troisième exemple d'intégration illustré à la figure 2C, une zone d'isolation 1000 selon la présente invention est intégrée à la fois entre les deux transistors NMOS 2000a, 2000b voisins et entre les deux transistors PMOS 2000a', 2000b' voisins.

Selon un quatrième exemple d'intégration illustré à la figure 2D, la zone d'isolation 1000 selon la présente invention est intégrée entre les deux transistors NMOS 2000a, 2000b voisins (ou entre les deux transistors PMOS 2000a', 2000b' voisins) et le motif électriquement conducteur 500 est discontinu, et connaît notamment une discontinuité entre la zone d'isolation 1000 séparant les transistors NMOS 2000a, 2000b et la portion du motif 500 séparant les transistors PMOS 2000a', 2000b'.

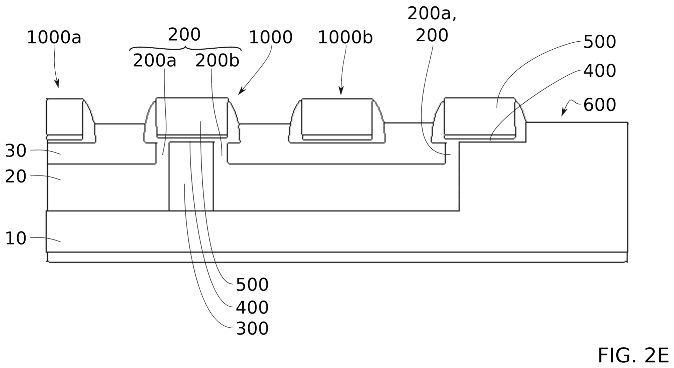

La figure 2E illustre la façon dont la présente invention peut être intégrée en bout de ligne active. Comme illustré, pour séparer une région 1000b d'une prise substrat 600 (prise bulk) se situant en bord de plaque (zones quadrillées sur les figures 2A à 2D), il est possible de former un espaceur 200a séparant la région 1000b du substrat 10 et de disposer au-dessus du substrat 10 une couche séparatrice 400 et un motif électriquement conducteur 500, comme dans les autres zones isolantes 1000. Cette zone d'isolation peut être fabriquée en même temps que les zones d'isolation séparant deux dispositifs. Il est notamment possible de former l'espaceur 200a en même temps que ceux des autres zones d'isolation, et de réaliser une épitaxie depuis le substrat 10 en même temps que la formation de le couche épitaxiée 300 des autres zones d'isolation. Les couches séparatrices 400 et les motifs 500 peuvent également être formés simultanément. La présente invention permet donc de réaliser simultanément toutes les zones d'isolation nécessaires sur un substrat.

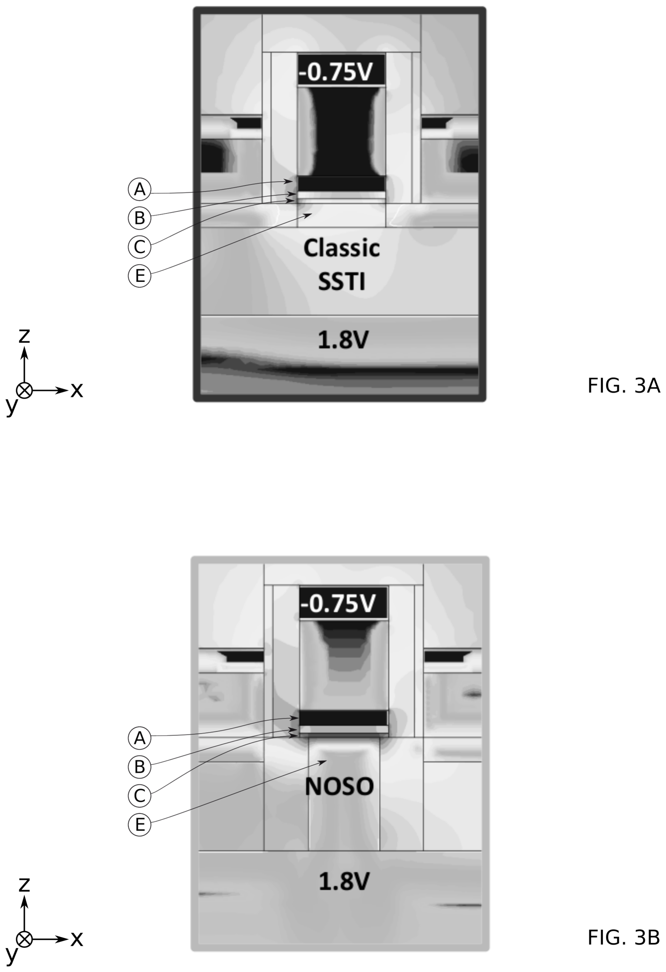

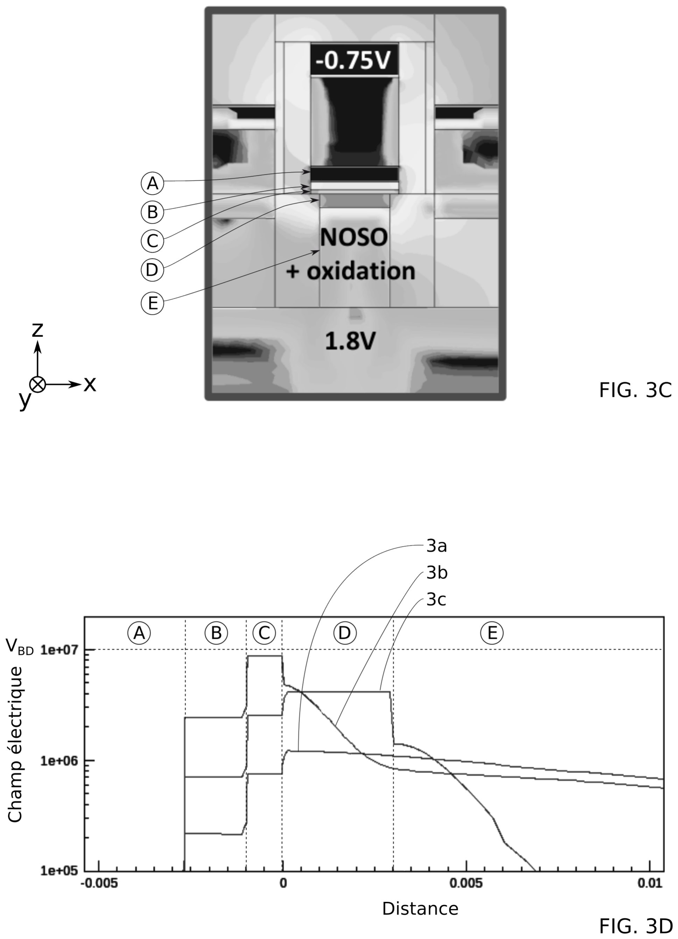

Les figures 3Aà 3D sont des résultats de simulations montrant l'intérêt de la présente invention.

Les figures 3Aà 3C illustrent la répartition du champ électrique au sein de différentes structures de transistors : la figure 3A correspond à une structure de l'art antérieur avec isolation classique STI, la figure 3B correspond à une structure présentant une isolation avec couche épitaxiée sous-jacente au transistor, tandis que la figure 3C correspond à une structure intégrant l'ensemble selon la présente invention, avec notamment une couche épitaxiée 300 sous-jacente et une couche séparatrice 400.

La figure 3D est un graphique montrant l'évolution du champ électrique en fonction de la profondeur selon la direction Z dans le dispositif. Différentes zones sont référencées à la fois sur les figures 3A à 3C et sur la figure 3D pour une meilleure compréhension des figures :
a. Zone « A » : correspond à la grille du transistor,
b. Zone « B » : correspond à une couche diélectrique (typiquement HfO₂),
c. Zone « C » : correspond à une inter couche (couramment désignée par le terme anglais de « inter layer ») d'oxyde, par exemple en SiO₂,
d. Zone « D » : uniquement présente sur la figure 3C relative à un ensemble selon la présente invention, elle correspond à la couche séparatrice 400,
e. Zone « E » : correspond à la couche épitaxiée 300.

Les courbes 3a, 3b et 3c de la figure 3D correspondent au champ électrique dans chacune des structures des figures 3A, 3B et 3C en fonction de la profondeur dans le dispositif.

On observe que dans le cas de la structure 3B, la valeur du champ électrique se rapproche très fortement de la valeur correspondant à la tension de claquage du dispositif. Les valeurs de champ électrique les plus élevées sont prises au niveau de l'inter couche (voir zone B sur la figure 3B). En fonctionnement, la valeur de la tension régnant dans certaines zones du transistor se rapproche donc de valeurs de tensions critiques, pouvant être synonymes d'altération voire de destruction du dispositif

On observe en comparaison que la tension régnant dans la structure mettant en œuvre la présente invention et illustré à la figure 3C ne s'élève pas à des valeurs aussi élevées. Notamment, le champ électrique au sein de l'inter layer est environ trois fois moins élevé que dans la même couche au sein de la structure de la figure 3B.

On observe par ailleurs que le champ électrique régnant dans la couche épitaxiée de la structure de la figure 3C est plus faible que dans les autres structures. Cela traduit notamment la réduction des capacités parasites sous le transistor.

Au travers des différents modes de réalisation décrits ci-dessus, il apparaît que la présente invention propose une solution efficace pour réaliser l'isolation de deux régions destinées à servir de base pour la fabrication de dispositifs microélectroniques tels que des transistors. L'invention résout efficacement la problématique d'isolation latérale entre dispositifs et celle des diodes parasites apparaissant typiquement dans les structures de l'art antérieur.

L'invention n'est pas limitée aux modes de réalisations précédemment décrits et s'étend à tous les modes de réalisation couverts par l'invention.

## Revendications

1. Dispositif microélectronique comprenant une isolation entre une première région (1000a) et une deuxième région (1000b), le dispositif comprenant un empilement (1) comprenant, selon une direction dite d'empilement (Z) :
• un substrat à base d'un premier matériau semiconducteur, dit substrat semiconducteur (10),
• une couche à base d'un matériau électriquement isolant, dite couche d'oxyde enterré (20),
• une couche à base d'un deuxième matériau semiconducteur, de préférence identique au premier matériau semiconducteur, dite couche mince (30),
l'empilement (1) comprenant une première région (1000a) et une deuxième région (2000b) séparées par une zone d'isolation (1000) s'étendant entre des flancs internes (1a, 1b) de l'empilement, la zone d'isolation (1000) traversant la couche mince (30) et la couche d'oxyde enterré (20) et débouchant sur le substrat semiconducteur (10),
le dispositif microélectronique comprenant en outre un premier transistor (2000a) et un deuxième transistor (2000b), le premier transistor (2000a) et le deuxième transistor (2000b) se situant respectivement dans la première et dans la deuxième région (1000a, 1000b), la couche mince (30) formant un premier canal du premier transistor (2000a) et un deuxième canal du deuxième transistor (2000b),
la zone d'isolation (1000) comprenant :
• un espaceur (200) s'étendant sur les flancs internes (1a, 1b) de l'empilement (1), l'espaceur (200) étant à base d'un matériau électriquement isolant,
• une couche à base du premier matériau semiconducteur, dite couche épitaxiée (300), s'étendant entre les flancs internes (1a, 1b) de l'empilement (1) et étant au contact du substrat (10),
• une couche à base d'un matériau électriquement isolant, dite couche séparatrice (400), s'étendant sur la couche épitaxiée (300), la couche séparatrice (400) recouvrant entièrement la couche épitaxiée (300),
• un motif électriquement conducteur (500) s'étendant sur la couche séparatrice (400),
la couche séparatrice (400) étant en contact direct avec la couche épitaxiée (300), le motif électriquement conducteur (500) étant en contact direct avec la couche séparatrice (400), la couche séparatrice (400) et le motif électriquement conducteur (500) étant agencés pour pouvoir autoriser ou non une circulation de courant dans la couche épitaxiée (300).

2. Dispositif selon la revendication précédente dans lequel la couche séparatrice (400) s'étend depuis une première portion (200a) de l'espaceur (200) recouvrant un premier flanc interne (1a) de l'empilement (1) jusqu'à une deuxième portion (200b) de l'espaceur (200) recouvrant un deuxième flanc interne (1b) de l'empilement (1) faisant face au premier flanc interne (1a).

3. Dispositif selon l'une quelconque des revendications précédentes dans lequel l'espaceur (200) présente une épaisseur e₂₀₀ mesurée selon une direction perpendiculaire aux flancs internes (1a, 1b) de l'empilement (1), avec e₂₀₀ supérieure ou égale à 4 nm et/ou inférieure ou égale à 10 nm, de préférence inférieure ou égale à 6 nm.

4. Dispositif selon l'une quelconque des revendications précédentes dans lequel l'espaceur (200) est enterré dans l'empilement (1), et de préférence ne s'étend pas au-delà d'une face supérieure (31) de la couche mince (30) opposée à la couche d'oxyde enterré (20), par exemple est affleurante à la face supérieure (31) de la couche mince (30).

5. Dispositif selon l'une quelconque des revendications précédentes dans lequel l'espaceur (200) traverse la couche mince (30) et la couche d'oxyde enterré (20) et de préférence s'étend jusqu'à une face supérieure (11) du substrat semiconducteur (10) se trouvant en regard de la couche d'oxyde enterré (20).

6. Dispositif selon l'une quelconque des revendications précédentes dans lequel le motif électriquement conducteur (500) présente des flancs (503) recouverts par des espaceurs secondaires (65), les espaceurs secondaires (65) étant directement en contact avec la couche séparatrice (400).

7. Dispositif selon la revendication précédente dans lequel la première région (1000a), la zone d'isolation (2000) et la deuxième région (1000b) sont disposés selon une première direction (X) perpendiculaire à la direction d'empilement (Z), dans lequel l'ensemble formé par le motif électriquement conducteur (500) et les espaceurs secondaires (65) présente une largeur E mesurée selon la première direction (X), et dans lequel la couche épitaxiée (300) présente une largeur L₃₀₀ mesurée selon la première direction (X), avec E>L₃₀₀.

8. Dispositif selon l'une quelconque des revendications précédentes dans lequel la couche séparatrice (400) présente une épaisseur e₄₀₀, mesurée selon la direction d'empilement (Z), supérieure ou égale à 3 nm.

9. Dispositif selon l'une quelconque des revendications précédentes dans lequel la couche épitaxiée (300) présente un dopage de type P ou de type N.

10. Procédé d'utilisation du dispositif selon l'une quelconque des revendications précédentes dans lequel le motif (500) est électriquement conducteur, le procédé comprenant en outre une étape de polarisation dudit motif (500).

11. Procédé de fabrication d'une zone d'isolation (1000) entre une première région (1000a) et une deuxième région (1000b) d'un dispositif microélectronique, le procédé comprenant les étapes suivantes :
• fournir un empilement (1) comprenant au moins, selon une direction dite d'empilement (Z) :
i. un substrat à base d'un premier matériau semiconducteur, dit substrat semiconducteur (10),
ii. une couche à base d'un matériau électriquement isolant, dite couche d'oxyde enterré (20),
iii. une couche à base d'un deuxième matériau semiconducteur, de préférence identique au premier matériau semiconducteur, dite couche mince (30),
• former une ouverture (100) dans l'empilement, l'ouverture (100) traversant la couche mince (30) et la couche d'oxyde enterré (20) et débouchant sur le substrat semiconducteur (10), l'ouverture (100) étant définie par des flancs internes (1a, 1b) de l'empilement (1), l'ouverture (100) séparant la première région (1000a) de la deuxième région (1000b) de l'empilement,
• former un espaceur (200) s'étendant depuis les flancs internes (1a, 1b) de l'empilement (1), l'espaceur (200) étant à base d'un matériau électriquement isolant,
• faire croître par épitaxie à partir du substrat semiconducteur (10) une couche dite épitaxiée (300) remplissant au moins partiellement l'ouverture (100),
• former sur la couche épitaxiée (300) une couche à base d'un matériau électriquement isolant dite couche séparatrice (400), la couche séparatrice (400) recouvrant entièrement la couche épitaxiée (300),
• former un motif électriquement conducteur (500) destiné à former un motif de grille sur la couche séparatrice (400), la couche séparatrice (étant en contact direct avec la couche épitaxiée (300), le motif électriquement conducteur (500) étant en contact direct avec la couche séparatrice (400), la couche séparatrice (400) et le motif électriquement conducteur (500) étant agencés pour autoriser ou non une circulation de courant dans la couche épitaxiée (300),
• former au moins un premier transistor (2000a) dans la première région (1000a) et au moins un deuxième transistor (2000b) dans la deuxième région (1000b), chaque transistor (2000a, 2000b) présentant un canal formé par la couche mince (30).

12. Procédé selon la revendication précédente dans lequel, à l'issue de la croissance épitaxiale, la couche épitaxiée (300) s'étend, selon la direction d'empilement (Z), au moins jusqu'à la moitié de la hauteur de la couche d'oxyde enterré (20), de préférence s'étend au moins jusqu'à une face supérieure (21) de la couche d'oxyde enterré (20) opposée au substrat (10), de préférence s'étend au moins jusqu'à une face supérieure (31) de la couche mince (30) opposée à la couche d'oxyde enterré (20), de préférence dépasse la couche mince (30).
